# EUROPEAN PATENT SPECIFICATION

(11) **EP 1 471 602 B1**
(45) Date of publication and mention of the grant of the patent: **15.03.2006**
(21) Application number: 04009310.6
(22) Date of filing: 20.04.2004
(51) Int. Cl.: H01Q 9/14, H01Q 23/00, H03J 5/24, H04N 5/50

(54) **Receive signal level optimisation through tuning of tunable antenna**
Empfangssignal-Pegel-Optimierung durch Abstimmung einer abstimmbaren Antenne
Optimisation du niveau d'un signal de réception par accord d'une antenne accordable

(30) Priority: 23.04.2003 JP 2003119035
(43) Date of publication of application: 27.10.2004
(73) Proprietor: ALPS ELECTRIC CO., LTD., Tokyo 145-8501 (JP)
(72) Inventor: Shigihara, Makoto, Ota-ku Tokyo 145-8501 (JP); Nakamura, Yusuke, Ota-ku Tokyo 145-8501 (JP)
(74) Representative: Klunker . Schmitt-Nilson . Hirsch

(56) References cited:
- GB-A- 311 821
- US-A- 4 048 598
- US-A- 4 339 827

## Description

### BACKGROUND OF THE INVENTION

### 1. Field of the Invention

The present invention relates to a portable receiver comprising an antenna device capable of resonating to a received signal and an electronic tuner unit for converting the received signal to an intermediate frequency signal.

### 2. Description of the Related Art ,

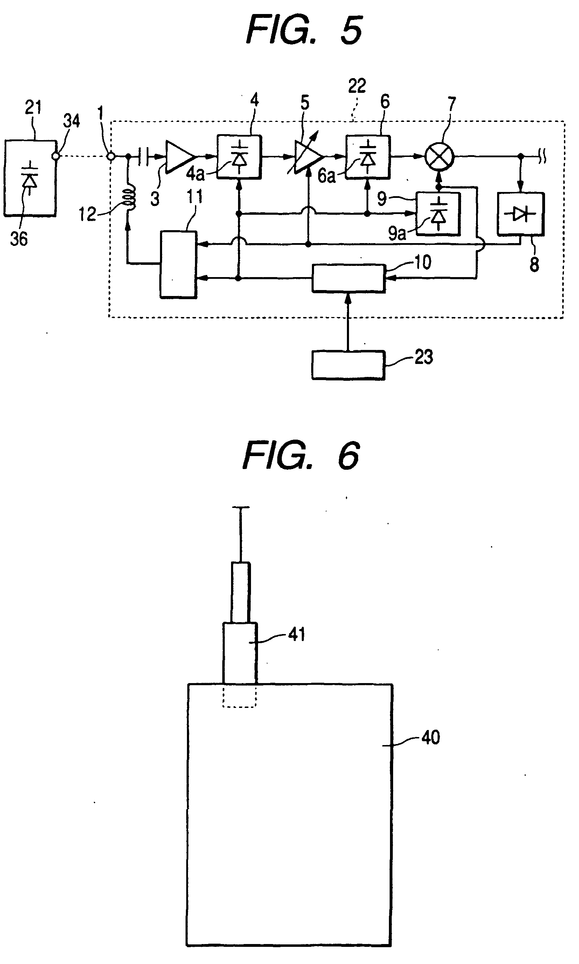

In a conventional portable receiver, such as a portable television receiver, as shown in Fig. 6, a retractable rod antenna 41 is provided on a receiver body 40 and protrude from it. A user operates the receiver body 40 to select the desired channel and adjusts the length of the rod antenna 40 to receive a television signal of the selected channel with the optimum sensitivity (for example, see Patent Document 1).
[Patent Document 1]
Japanese Unexamined Patent Application Publication No. 2001-339329 (Fig. 2)

However, in the conventional portable receiver, since the user operates both the receiver body and rod antenna for receiving signals, an operation for signal reception become complicated. In particular, since the length of the rod antenna is adjusted by the user's hands, the reception characteristics of the rod antenna change under the influence of the human body, and thus it is not easy to adjust the sensitivity of the reception channel.

The patent GB311821 discloses a receiver in which the resonance frequency of the antenna, the local oscillator frequency and the resonance frequency of a tuning circuit in the receiver can all be adjusted in parallel by tuning variable capacitors in each of these elements.

### SUMMARY OF THE INVENTION

Accordingly, it is an object of the present invention to present a portable receiver in which an antenna is automatically adjusted to obtain the optimum reception sensitivity when a receiver body is operated to receive signals, and thus a user does not need to adjust the antenna. The object is solved by a portable receiver according to claim 1.

In order to achieve this object, a portable receiver comprises: an antenna device in which a radiation conductor formed in a dielectric block and a first varactor diode coupled to the radiation conductor are embeded and that is capable of resonating to a received signal; and an electronic tuner unit for converting the received signal to an intermediate frequency signal, wherein the electronic tuner unit comprises: a variable tuning circuit having a second varactor diode; a mixer for frequency-converting; and an oscillator that has a third varactor diode and supplies a local oscillation signal to the mixer, and wherein a control voltage applied to the second varactor diode and the third varactor diode is applied to the first varactor diode to equalize a resonance frequency of the antenna device with a resonance frequency of the variable tuning circuit.

In addition, according to the present invention, a portable receiver comprises: an antenna device in which a radiation conductor formed in a dielectric block and a first varactor diode coupled to the radiation conductor are embedded and that is capable of resonating to a received signal; and an electronic tuner unit for converting the received signal to an intermediate frequency signal, wherein the electronic tuner unit comprises: a variable tuning circuit having a second varactor diode to which a control voltage is applied; a mixer for frequency-converting; an oscillator that has a third varactor diode to which the control voltage is applied and that supplies a local oscillation signal to the mixer; a detecting circuit for detecting the intermediate frequency signal to generate a DC voltage proportional to the level of the intermediate frequency signal; and a control voltage correction circuit for correcting the control voltage by using the DC voltage and for supplying the corrected control voltage to the first varactor diode, and wherein the control voltage is corrected so as to increase the level of the intermediate frequency signal, and to equalize a resonance frequency of the antenna device with a resonance frequency of the variable tuning circuit.

Furthermore, according to another aspect of the present invention, the control voltage is applied to the first varactor diode through a transmission path for the received signal input from the antenna device to the electronic tuner unit.

Moreover, according to another aspect of the present invention, channel selection data for selecting the received signal from a channel selection unit is input to the PLL circuit.

### BRIEF DESCRIPTION OF THE DRAWINGS

Fig. 1 is a conceptional view illustrating a portable receiver according to the present invention;
Fig. 2 is a perspective view illustrating an antenna device used in the portable receiver according to the present invention;
Fig. 3 is a bottom view illustrating the antenna device used in the portable receiver according to the present invention;
Fig. 4 is a circuit diagram illustrating the structure of an electronic tuner unit;
Fig. 5 is a circuit diagram illustrating the structure of another electronic tuner unit used in the portable receiver according to the present invention; and
Fig. 6 is a conceptional view illustrating a conventional portable receiver.

### DESCRIPTION OF THE PREFERRED EMBODIMENT

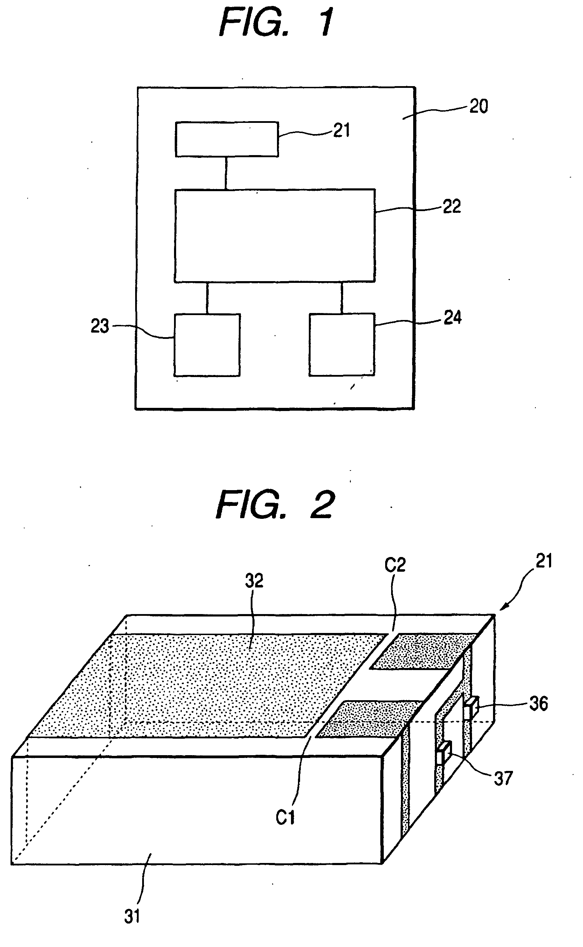

A television receiver, which is an embodiment of a portable receiver according to the present invention, will now be described with reference to Figs. 1 to 5. Fig. 1 is a conceptional view illustrating the television receiver, and a receiver body 20 comprises an antenna device 21, an electronic tuner unit 22, a channel selection unit 23, and a display unit 24. A television signal selected by the channel selection unit 23 is received by the antenna device 21, and the received signal is converted into an intermediate frequency signal by the electric tuner unit 22. Then, the intermediate frequency signal is processed by another circuit in the receiver body 20, and an image is then displayed on the display unit.

The antenna device 21 does not have to be accommodated in the receiver body 20, and may be mounted on the outside of the receiver body 20.

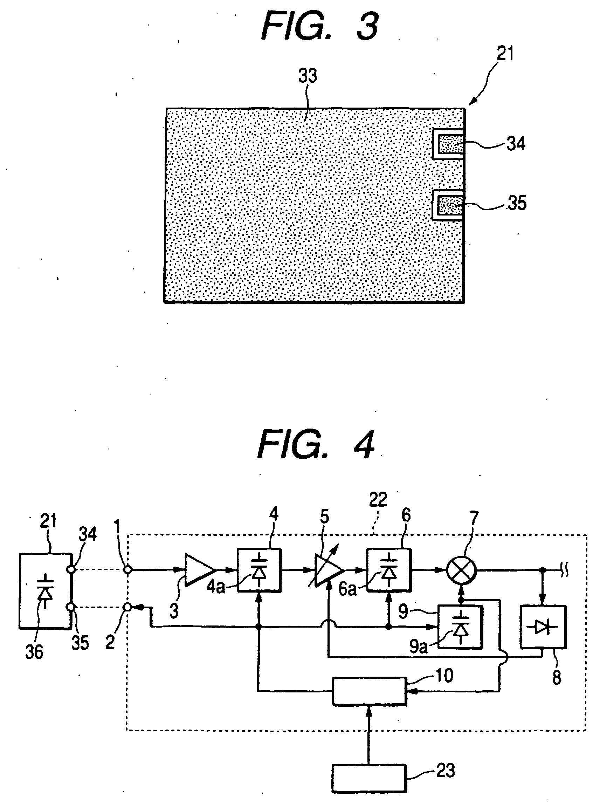

The antenna device 21, as shown in Figs. 2 and 3, is an inverted F-type dielectric antenna in which a radiation conductor 32, an earth conductor 33, a feeding terminal 34, and a control terminal 35 are provided on the surface of a rectangular parallelepiped dielectric block 31. The radiation conductor 32 has two capacity-coupling portions C1 and C2 on the upper surface of the dielectric block 31, and the capacity-coupling portions C1 and C2 enable impedance matching and the adjustment of the value of an additional capacity.

In addition, a high-frequency feeding voltage is supplied to the feeding terminal 34, and a DC bias voltage (a control voltage) is supplied to the control terminal 35. A first varactor diode 36 and a resistor 37 are provided on the side surface of the dielectric block 31. The first varactor diode 36 is a variable capacitive element of which the value of capacity is varied according to the magnitude of the applied DC bias voltage. A cathode of the varactor diode 36 is connected to the resistor 37 for blocking a high frequency, and an anode thereof is connected to the earth conductor 33. The resistor 37 is connected to the control terminal 35, and a DC bias voltage is supplied to the varactor diode 36 through the resistor 37.

The antenna device 21 constructed as described above is encased in a case (not shown) so as not to contact with peripheral circuits, and the case is accommodated in the receiver body 20.

As shown in Fig. 4, the electronic tuner unit 22 comprises an input terminal 1 and a control voltage output terminal 2 connected to the feeding terminal 34 and the control terminal of the antenna device 21, respectively, a pre-amplifier 3 connected to the input terminal 1, an input tuning circuit 4 provided at the next stage of the pre-amplifier 3, a variable gain amplifier 5 provided at the next stage of the input tuning circuit 4, an output tuning circuit 6 provided at the next stage of the variable gain amplifier 5, a mixer 7 provided at the next stage of the output tuning circuit 6, a detecting circuit 8 provided at the next stage of the mixer 7, an oscillator 9 for supplying a local oscillation signal to the mixer 7, and a phase locked loop (PLL) circuit 10 for controlling an oscillation frequency of the oscillator 9.

The input tuning circuit 4 and the output tuning circuit 6, which have second varactor diodes 4a and 6a, respectively, are variable tuning circuits of which tuning frequencies are varied by the second varactor diodes 4a and 6a. In addition, the oscillator 9 is provided with a third varactor diode 9a. An oscillation frequency is determined by the third varactor diode 9a.

The local oscillation signal from the oscillator 9 and the channel selection data from the channel selection unit 23 are input into the PLL circuit 10. Then, the control voltage output from the PLL circuit 10 is supplied to the second varactor diodes 4a and 6a of the input tuning circuit 4 and the output tuning circuit 6, and is also supplied to the third varactor diode 9a of the oscillator 9. In this way, the two tuning circuits 4 and 6 are tuned to a frequency determined by the capacity values of the second varactor diodes 4a and 6a, and the oscillator also oscillates at a predetermined frequency. Furthermore, the control voltage is applied to the control voltage output terminal 2. Thus, since the control voltage is also applied to the first varactor diode 36 of the antenna device 21, the antenna device 21 resonates to a frequency determined by the capacity value of the first varactor diode 36. The resonance frequency is set to be equal to the tuning frequency of the tuning circuits 4 and 6.

In the aforementioned construction, when the channel selection unit 23 selects a channel to be input, the control voltage corresponding to the channel is output from the PLL circuit 10. Then, the antenna device 21 resonates to the frequency determined by the capacity value of the first varactor diode 36, as described above. Therefore, a television signal of the frequency is received with the highest sensitivity, and the received signal is then input from the feeding terminal 34 to the electronic tuner unit 22. The input television signal is amplified by the pre-amplifier 3 and the variable gain amplifier 4, and unnecessary signal components are removed from the television signal by the input tuning circuit 4 and the output tuning circuit 6. Then, the signal is input to the mixer 7. In the mixer 7, the signal is mixed with the local oscillation frequency and is converted into the intermediate frequency signal. A portion of the intermediate frequency signal is detected by the detecting circuit 8 and is converted into a DC voltage. Then, the DC voltage is supplied to the variable gain amplifier 5 as an AGC voltage, and, as a result, the intermediate frequency signal is controlled to have a constant level.

As described above, in the present invention, since the antenna 21 resonates to the frequency of the channel to be received, only by the channel-selecting operation of the receiver body, a complicated operation for signal reception is not required.

In addition, in the antenna device 21, the resistor 37 may be connected between the first varactor diode 36 and the feeding terminal 34, and the control terminal 35 may be removed. In this case, the control voltage output terminal 2 may be removed from the electronic tuner unit 22, and the control voltage may be applied to the input terminal 1 through high frequency blocking means (see reference numeral 12 in Fig. 5). Therefore, the, control voltage is supplied to the first varactor diode 36 through a transmission path (herein, a line connecting the feeding terminal 34 to the input terminal 1) for the television signal input from the antenna device 21 to the electronic tuner unit 22.

Fig. 5 shows the structure of another embodiment of the electronic tuner unit 22. In Fig. 5, the same components as those in Fig. 4 have the same reference numerals, and a description thereof will be omitted for simplicity of explanation. The control voltage output from the PLL circuit 10 is applied to the respective varactor diodes 4a, 6a, and 9a of the input tuning circuit 4, the output tuning circuit 6, and the oscillator 9 and is also applied to the first varactor diode 36 through a control voltage correction circuit 11. That is, the corrected control voltage output from the control voltage correction circuit is applied to the input terminal through an inductance element 12, which is high frequency blocking means.

The DC voltage from the detecting circuit 8 is input to the control voltage correction circuit 11 that corrects the input control voltage by using the DC voltage and outputs the corrected voltage. The operation of the control voltage correction circuit 11 will be described hereinafter.

The control voltage correction circuit 11 outputs a control voltage Vt first output from the PLL circuit 10 as it is (without making a change) and stores a DC voltage Vd at that time. Then, the control voltage correction circuit 11 increases the control voltage by ΔVt, and compares the DC voltage previously stored therein with the DC voltage output after an increase of the control voltage. As a result of comparison, when the late DC voltage is larger than the previous DC voltage (when the level of the intermediate frequency signal increases), the control voltage correction circuit 11 outputs the control voltage further raised by ΔVt.

If the late DC voltage becomes less than the previously stored DC voltage by the repetition of the above operation, the control voltage correction circuit 11 decreases the subsequent output control voltage by ΔVt and compares the DC voltage previously stored therein with the DC voltage output after a decrease of the control voltage. As a result of comparison, when the DC voltage is varied in the descending direction, the control voltage correction circuit 11 outputs the control voltage increased by ΔVt. On the contrary, when the DC voltage is varied in the ascending direction, the control voltage correction circuit 11 outputs the control voltage decreased by ΔVt. Therefore, the intermediate frequency signal is always maintained at the highest level.

Therefore, in the case of operating a portable receiver using the user's hands, even when the resonance frequency of the antenna device 21 is varied under the influence of the human body, the control voltage to be supplied to the antenna device 21 is corrected, and thus the desired television signal can always be received with the highest sensitivity.

As described above, according to the present invention, an electronic tuner unit comprises a variable tuning circuit having a second varactor diode, a mixer for frequency-converting, and an oscillator that has a third varactor diode and supplies a local oscillation signal to the mixer, wherein a control voltage applied to the second varactor diode and the third varactor diode is applied to the first varactor diode to equalize a resonance frequency of the antenna device with a resonance frequency of the variable tuning circuit. Therefore, the antenna device resonates to the frequency of the channel to be received only by a channel-selecting operation, and a complicated operation of the antenna device is not required.

In addition, an electronic tuner unit comprises a variable tuning circuit having a second varactor diode to which a control voltage is applied, a mixer for frequency-converting, an oscillator that has a third varactor diode to which the control voltage is applied and that supplies a local oscillation signal to the mixer, a detecting circuit for detecting an intermediate frequency signal to generate a DC voltage proportional to the level of the intermediate frequency signal, and a control voltage correction circuit for correcting the control voltage by using the DC voltage and for supplying the corrected control voltage to the first varactor diode, wherein the control voltage to be supplied to the first varactor diode is corrected so as to increase the level of the intermediate frequency signal, and to equalize a resonance frequency of the antenna device with a resonance frequency of the variable tuning circuit. Therefore, in the case of operating a portable receiver using the user's hands, even when the resonance frequency of the antenna device is varied under the influence of the human body, the control voltage to be supplied to the antenna device 21 is corrected, and thus the desired television signal can always be received with the highest sensitivity.

Furthermore, the control voltage is applied to the first varactor diode through a transmission path for the received signal input from the antenna device to the electronic tuner unit. Therefore, the antenna device and the electronic tuner unit each have a terminal, and their terminals are connected to each other, thereby simplifying the structure of them.

Moreover, the electronic tuner unit further comprises a PLL circuit for generating the control voltage, and channel selection data for selecting the received signal from a channel selection unit is input to the PLL circuit. Therefore, it is possible to simply tune the antenna device and the electronic tuner unit to the received signal.

## Claims

1. A portable receiver, comprising:
an antenna device (21) in which a radiation conductor (32) formed in a dielectric block (31) and a first varactor diode (36) coupled to the radiation conductor are embedded and that is capable of resonating to a received signal; and
an electronic tuner unit (22) for converting the received signal to an intermediate frequency signal,
wherein the electronic tuner unit (22) comprises:
a variable tuning circuit (4, 6) having a second varactor diode (4a, 6a), to which a first control voltage is applied;
a mixer (7) for frequency-converting the output of sait variable tuning circuit and outputting said intermediate frequency,
an oscillator (9) that has a third varactor diode (9a) to which the first control voltage is applied and that supplies a local oscillation signal to the mixer;
a phase locked loop circuit (10) for receiving the signal from the oscillator (9) to generate the first control voltage;
a detecting circuit (8) for detecting the intermediate frequency signal to generate a DC voltage proportional to the level of the intermediate frequency signal; and
a control voltage correction circuit (11) for correcting the first control voltage by using the DC voltage and for supplying a second control voltage obtained by correcting the first control voltage only to the first varactor diode (36), and
for correcting the first control voltage so as to increase the level of the intermediate frequency signal and to equalize a resonance frequency of the antenna device with a resonance frequency of the variable tuning circuit.

2. The portable receiver according to Claim 1, further comprising means for applying
the control voltage the first varactor diode (36) through a transmission path for the received signal input from the antenna device (21) to the electronic tuner unit (22).

3. The portable receiver according to Claims 1 or 2, further comprising means for inputting
channel selection data for selecting the received signal from a channel selection unit (23) to the PLL circuit (10).

## Patentansprüche

1. Tragbarer Empfänger, aufweisend:
eine Antennenvorrichtung (21), in der ein in einem dielektrischen Block (31) gebildeter Strahlungsleiter (32) und eine mit dem Strahlungsleiter gekoppelte erste Varaktordiode (36) eingebettet sind und die dazu in der Lage ist, mit einem empfangenen Signal in Resonanz mitzuschwingen; und
eine elektrische Abstimmeinheit (22) zum Umwandeln des empfangenen Signals in ein Zwischenfrequenzsignal,
wobei die elektronische Abstimmeinheit (22) aufweist:
eine variable Abstimmschaltung (4, 6) mit einer zweiten Varaktordiode (4a, 6a), an die eine erste Steuerspannung angelegt wird;
einen Mischer (7) zum Frequenzwandeln der Ausgabe der variablen Abstimmschaltung und zum Ausgeben der Zwischenfrequenz,
einen Oszillator (9), der eine dritte Varaktordiode (9a) hat, an die die erste Steuerspannung angelegt wird, und der dem Mischer ein lokales Schwingungssignal liefert;
eine phasenstarre Schleifenschaltung (10) zum Empfangen des Signals von dem Oszillator (9) für die Erzeugung der ersten Steuerspannung;
eine Detektierungsschaltung (8) zur Detektierung des Zwischenfrequenzsignals für die Erzeugung einer Gleichstromspannung, die proportional zu dem Pegel des Zwischenfrequenzsignals ist; und
eine Steuerspannungskorrekturschaltung (11) zur Korrektur der ersten Steuerspannung mittels der Gleichstromspannung und zur Beaufschlagung nur der ersten Varaktordiode (36) mit einer zweiten Steuerspannung, die durch die Korrektur der ersten Steuerspannung erlangt wird, und
zur Korrektur der ersten Steuerspannung, um den Pegel des Zwischenfrequenzsignals zu erhöhen und um eine Resonanzfrequenz der Antennenvorrichtung einer Resonanzfrequenz der variablen Abstimmschaltung anzugleichen.

2. Tragbarer Empfänger nach Anspruch 1,
ferner aufweisend eine Einrichtung zur Anlegung der Steuerspannung an die erste Varaktordiode (36) durch einen Übertragungspfad für das empfangene Signal, das der elektronischen Abstimmeinheit (22) von der Antennenvorrichtung (21) zugeführt wird.

3. Tragbarer Empfänger nach Anspruch 1 oder 2,
ferner aufweisend eine Einrichtung zur Zuführung von Kanalauswahldaten für die Auswahl des empfangenen Signals von einer Kanalauswahleinheit (23) in die PLL-Schaltung (10).

## Revendications

1. Récepteur portable comprenant :
un dispositif formant antenne (21) dans lequel sont intégrés un conducteur de rayonnement (32) formé dans un bloc diélectrique (31) et une première diode à capacité variable (36) couplée au conducteur de rayonnement et qui est capable de résonner sur un signal reçu ; et
une unité d'accord électronique (22) pour convertir le signal reçu en un signal de fréquence intermédiaire,
dans lequel l'unité d'accord électronique (22) comprend :
un circuit d'accord variable (4, 6) comportant une deuxième diode à capacité variable (4a, 6a), à laquelle est appliquée une première tension de commande ;
un mélangeur (7) pour convertir en fréquence la sortie dudit circuit d'accord variable et délivrer en sortie ladite fréquence intermédiaire ;
un oscillateur (9) qui comporte une troisième diode à capacité variable (9a) à laquelle est appliquée la première tension de commande et qui fournit un signal d'oscillation local au mélangeur ;
un circuit à boucle à phase asservie (10) destiné à recevoir le signal de l'oscillateur (9) pour générer la première tension de commande ;
un circuit de détection (8) pour détecter le signal de fréquence intermédiaire afin de générer une tension continue proportionnelle au niveau du signal de fréquence intermédiaire ; et
un circuit de correction de tension de commande (11) pour corriger la première tension de commande en utilisant la tension continue et pour fournir une deuxième tension de commande obtenue en corrigeant la première tension de commande seulement à la première diode à capacité variable (36), et pour corriger la première tension de commande de manière à augmenter le niveau du signal de fréquence intermédiaire et à égaliser une fréquence de résonance du dispositif formant antenne avec une fréquence de résonance du circuit d'accord variable.

2. Récepteur portable selon la revendication 1, comprenant en outre un moyen permettant d'appliquer la tension de commande à la première diode à capacité variable (36) via un chemin de transmission pour le signal reçu transmis par le dispositif formant antenne (21) à l'unité d'accord électronique (22).

3. Récepteur portable selon la revendication 1 ou 2, comprenant en outre un moyen permettant d'entrer des données de sélection de voie pour choisir le signal reçu d'une unité de sélection de voie (23) dans le circuit PLL (10).
